(19) Europäisches Patentamt / European Patent Office / Office européen des brevets

(11) EP 3 825 711 A1

(12) EUROPEAN PATENT APPLICATION

(43) Date of publication:
26.05.2021 Bulletin 2021/21

(51) Int Cl.:
G01R 33/56 (2006.01)        G06N 3/08 (2006.01)
G06T 5/00 (2006.01)         G06T 9/00 (2006.01)
G06T 11/00 (2006.01)        G06N 3/04 (2006.01)

(21) Application number: 19211148.2

(22) Date of filing: 25.11.2019

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
KH MA MD TN

(71) Applicant: Koninklijke Philips N.V.
5656 AG Eindhoven (NL)

(72) Inventors:
• PEZZOTTI, Nicola
  5656 AE Eindhoven (NL)
• SCHUELKE, Christophe
  5656 AE Eindhoven (NL)

(74) Representative: Philips Intellectual Property &
Standards
High Tech Campus 5
5656 AE Eindhoven (NL)

(54) HYBRID COMPRESSED SENSING IMAGE RECONSTRUCTION

(57) Disclosed herein is a medical instrument (100, 300) comprising a memory (110) storing machine executable instructions (120), a convolutional neural network (122, 122', 122", 122'''), and a compressed sensing data-consistency module (124). The convolutional neural network is configured to output a de-noised magnetic resonance image (132) in response to inputting an input magnetic resonance image (130) and is a multiscale deep neural network. Execution of the machine executable instructions causes the processor to provide a reconstructed magnetic resonance image (136) reconstructed from measured k-space data (126) by iteratively using the convolutional neural network and the compressed sensing data-consistency module to implement a magnet resonance imaging compressed sensing reconstruction.

Fig. 5

**Description**

FIELD OF THE INVENTION

The invention relates to Magnetic Resonance Imaging, in particular to compressed sensing magnetic resonance imaging.

BACKGROUND OF THE INVENTION

A large static magnetic field is used by Magnetic Resonance Imaging (MRI) scanners to align the nuclear spins of atoms as part of the procedure for producing images within the body of a patient. This large static magnetic field is referred to as the B0 field or the main magnetic field. Various quantities or properties of the subject can be measured spatially and imaged using MRI.

Compressed sensing (CS) is one means of reducing the time required to acquire the k-space data for a magnetic resonance image. Medical images can typically be compressed or have a sparse representation. The idea behind compressed sensing is that because the medical image can have a sparse representation it is possible to acquire and reconstruct the image by sampling less k-space data than is required by the Nyquist criterion (herein referred to an under sampling). To do this, the k-space data is sampled so that the artifacts due to under sampling appear in image space as random noise.

To reconstruct the image an iterative process is used. First, the image is reconstructed from the acquired or measured k-space data. In conventional CS a filter module transforms the image into to a sparse representation, such as a wavelet representation. The transformed image is then thresholded to remove noise and typically changed back to image space to produce a de-noised image. A data consistency module is then used to refine the image. The data consistency module takes the de-noised image and adjusts it so that the k-space transform of the image is more consistent with the measured k-space data. The effect of this is that the noise and artefacts due to the under sampling is reduced. The image can then be improved by iteratively processing the image with the filter module and the data consistency module.

The conference publication Zhang, J., & Ghanem, B. (2018). ISTA-Net: Interpretable optimization-inspired deep network for image compressive sensing. In Proceedings of the IEEE Conference on Computer Vision and Pattern Recognition (pp. 1828-1837) discloses an algorithm for compressive sensing (CS) reconstruction of natural images. It combines two existing categories of CS methods: the structure insights of traditional optimization-based methods and the performance/speed of recent network-based ones. Disclosed is a structured deep network, dubbed ISTA-Net, which is inspired by the Iterative Shrinkage-Thresholding Algorithm (ISTA) for optimizing a general L1 norm CS reconstruction model. To cast ISTA into deep network form, it uses a strategy to solve the proximal mapping associated with the sparsity-inducing regularizer using nonlinear transforms. All the parameters in ISTA-Net (e.g. nonlinear transforms, shrinkage thresholds, step sizes, etc.) are learned end-to-end, rather than being hand-crafted.

SUMMARY OF THE INVENTION

The invention provides for a medical instrument, a computer program product, and a method in the independent claims. Embodiments are given in the dependent claims.

Embodiments may provide for an improved compressed sensing reconstruction algorithm. Embodiments may provide this by using a convolutional neural network as the filter module in the compressed sensing algorithm. This convolutional neural network is a multiscale deep neural network. Using a multiscale deep neural network is that it acts on multiple scales and may therefore provide more accurate denoising of an image.

In one aspect the invention provides for a medical instrument that comprises a memory storing machine-executable instructions, a convolutional neural network, and a compressed sensing data-consistency module. The convolutional neural network is configured to output a de-noised magnetic resonance image in response to inputting an input magnetic resonance image. The convolutional neural network is a multi-scale deep neural network. Deep neural networks comprise skip layers. By multi-scale there may be pool layers and upsampling layers to change the size of the image in a particular layer.

The convolutional neural network comprises a first portion implementing a sparsifying transform. The compressed sensing data-consistency module is configured to generate an intermediate image by increasing consistency of the magnetic resonance image with the measured k-space values. The convolutional neural network outputs a de-noised magnetic resonance image. The compressed sensing data-consistency module then modifies the de-noised magnetic resonance image into the intermediate image. It does this by making the representation of the de-noised magnetic resonance image more consistent with the measured k-space values. Often times this is typically done by the solution of an optimization problem.

The medical instrument further comprises a processor configured to control the medical instrument. Execution of the machine-executable instructions causes the processor to receive the measured k-space data. Execution of the machine-executable instructions further causes the processor to reconstruct an initial magnetic resonance image from the measured k-space data. This is typically done with an algorithm that takes the initial magnetic resonance image as input and the Fourier transforms reconstructs the initial magnetic resonance image. Execution of the machine-executable instructions further causes the processor to set the initial magnetic resonance image as the input magnetic resonance image.

The input magnetic resonance image is then used in an iterative process. Execution of the machine-executable instructions further causes the processor to iteratively generate the intermediate magnetic resonance image and the de-noised magnetic resonance image by repeating the following steps a predetermined number of times. The steps include receiving the de-noised magnetic resonance image from the convolutional neural network in response to inputting the input magnetic resonance image into the convolutional neural network. These steps further comprise receiving the intermediate image from the compressed sensing data-consistency module in response to inputting the de-noised magnetic resonance image and the measured k-space data. In these iterations the intermediate image is then input into the convolutional neural network to receive a new de-noised magnetic resonance image and this process continues for the set number of iterations. It should be noted that the iteration can be broke when either the de-noised magnetic resonance image has been constructed a predetermined number of times or the intermediate image has been reconstructed a predetermined number of times.

After the iterative steps are complete execution of the machine-executable instructions further causes the processor to provide the intermediate magnetic resonance image or the de-noised magnetic resonance image as a reconstructed magnetic resonance image. Both the intermediate magnetic resonance image and the de-noised magnetic resonance image may be suitable for the final product. An implicit step in this iterative process is setting the intermediate magnetic resonance image as the input image to repeat the iterative generation of the intermediate magnetic resonance image and the de-noised magnetic resonance image.

In some embodiments the sampled k-space data may be compressed sensing magnetic resonance imaging data.

The compressed sensing data-consistency module works for example by solving optimization problems or by replacing the k-space values of the de-noised magnetic resonance image by measured k-space data at measured locations.

In another embodiment the first portion of the convolutional neural network which implements the sparsifying transform comprises a first rectifier unit layer. The first portion further comprises a first pooling layer. The first rectifier unit is before the first pooling layer. It is understood that in convolutional neural networks there is a flow from one layer to the next. If one unit or layer is identified as being before a particular layer it implies that the later layer is later in the signal flow through the convolutional neural network. The first portion further comprises a second rectifier unit after the first pooling layer. The convolutional neural network further comprises a second pooling layer.

The second pooling layer is after the second rectifier unit. The first portion further comprises a first upsampling layer after the second pooling layer. The convolutional neural network further comprises a first concatenation layer after the first upsampling layer. The convolutional neural network further comprises a second upsampling layer after the first concatenation layer. The convolutional neural network further comprises a second concatenation layer after the second upsampling layer. The convolutional neural network further comprises a first skip connection between the first rectifier layer and the second concatenation layer. The data flows from the first rectifier layer to the second concatenation layer.

The convolutional neural network further comprises a second skip connection between the second rectifier layer and the first concatenation layer. Likewise, data information flows from the second rectifier layer to the first concatenation layer. This embodiment may be beneficial because it provides a framework for implementing the multi-scale deep neural network.

In another embodiment the first portion further comprises a first convolutional layer before the first rectifier layer. In some instances, this first convolutional layer may be an input. In some examples this first convolutional layer is replaced with multiple convolutional layers and rectifier units. The first portion further comprises a second convolutional layer after the first pooling layer but before the second rectifier layer. Likewise, this second convolutional layer may be replaced with multiple convolutional layers and rectifier units.

In another embodiment the first portion further comprises a first intermediate convolutional layer after the second pooling layer but before the first upsampling layer. The convolutional neural network further comprises a first intermediate rectifier layer after the first intermediate convolutional layer but before the first upsampling layer. The first portion further comprises a second intermediate convolutional layer after the first intermediate rectifier layer but before the first upsampling layer. The first portion further comprises a second intermediate rectifier layer after the second intermediate convolutional layer but before the first upsampling layer. In this embodiment there are two convolutional layer and rectifier unit pairs with a reduced dimension. In some embodiments the second intermediate convolutional layer and the second intermediate rectifier layer may be removed. In other embodiments there are additional convolutional layers and rectifier layers after the second intermediate rectifier layer.

In another embodiment the first portion further comprises a third convolutional layer after the first concatenation layer but before the second upsampling layer. The first portion further comprises a third rectifier layer after the third convolutional layer but before the second upsampling layer.

In another embodiment the combination of the third convolutional layer and the third rectifier layer is replaced by multiple groups of convolutional layers and rectifier layers.

In another embodiment the first portion further comprises a fourth convolutional layer after the second concatenation layer and the first portion further comprises a fourth rectifier layer after the fourth convolutional layer. In some examples the fourth rectifier layer is the output of the first portion. In some other embodiments there may be additional convolutional layers and rectifier layers after the fourth rectifier layer.

In another embodiment the first portion is configured to output an intermediate sparsified image representation. The convolutional neural network further comprises a trained filter layer configured for receiving the sparsified image representation and in response outputting a filtered sparsified image representation. The convolutional neural network further comprises a second neural network portion configured for outputting the de-noised magnetic resonance image in response to receiving the filtered sparsified image representation. This embodiment may be beneficial because using the multi-scale deep neural network the filtering of the input magnetic resonance image is much more effective.

In another embodiment if the fourth rectifier layer is present then the trained filter layer may be after the fourth rectifier layer.

In another embodiment the second portion comprises a fifth rectifier unit layer. The second portion further comprises a third pooling layer. The third pooling layer is after the fifth rectifier unit layer. The second portion further comprises a sixth rectifier unit layer after the third pooling layer. The second portion further comprises a fourth pooling layer. The fourth pooling layer is after the sixth rectifier unit layer. The second portion further comprises a third upsampling layer after the fourth pooling layer. The second portion further comprises a third concatenation layer after the third upsampling layer. The second portion further comprises a fourth upsampling layer after the third concatenation layer. The second portion further comprises a fourth concatenation layer after the fourth upsampling layer. The second portion further comprises a third skip connection between the fifth rectifier layer and the fourth concatenation layer. The second portion further comprises a fourth skip connection between the sixth rectifier layer and the third concatenation layer.

In another embodiment the second portion further comprises a fifth convolutional layer before the fifth rectifier unit layer. In some examples the fifth convolutional layer may be considered to be the input of the second part. The second portion further comprises a sixth convolutional layer after the third pooling layer but before the sixth rectifier unit layer.

In another embodiment the second portion further comprises a third intermediate convolutional layer after the fourth pooling layer but before the third upsampling layer. The second portion further comprises a third intermediate rectifier layer after the third intermediate convolutional layer but before the third upsampling layer. The second portion further comprises a fourth intermediate convolutional layer after the third intermediate rectifier layer but before the third upsampling layer. The second portion further comprises a fourth intermediate rectifier unit layer after the fourth intermediate convolutional layer but before the third upsampling layer.

In another embodiment the second portion further comprises a seventh convolutional layer after the third concatenation layer but before the fourth upsampling layer. The second portion further comprises a seventh rectifier layer after the third convolutional layer but before the fourth upsampling layer.

In another embodiment the second portion further comprises an eighth convolutional layer after the fourth concatenation layer. The second portion further comprises an eighth rectifier layer after the eighth convolutional layer. In some examples the eighth rectifier layer may be considered to be the output of the convolutional neural network.

In another embodiment the first neural network portion and the second neural network portion are symmetric. This may be beneficial because it may provide for very effective filtering of the initial magnetic resonance image.

In another embodiment the first neural network portion and the second neural network portion are asymmetric. For example, the second neural network portion may be smaller than the first neural network portion. This may be beneficial because it may reduce the computational needs of operating the convolutional neural network.

In another embodiment the first portion is configured to output the de-noised magnetic resonance image. The first portion in this embodiment functions as both the portion implementing the sparsifying transform as well as reconstructing the de-noised magnetic resonance image.

In another embodiment the first portion further comprises a first trainable filter layer between the first concatenation layer and the second upsampling layer. The first portion further comprises a second trainable filter layer after the second concatenation layer. This embodiment may be beneficial because it may provide for a compact yet effective convolutional neural network for providing the de-noised magnetic resonance image.

In another embodiment if the third convolutional layer is present then the first trainable filter layer may be between the first concatenation layer and the third convolutional layer. If the fourth convolutional layer is present then the second trainable filter layer may be between the second concatenation layer and the fourth convolutional layer.

In another embodiment the measured k-space data is parallel imaging k-space data. In parallel magnetic resonance imaging multiple antennas are used to collect the magnetic resonance imaging data and they are reconstructed with coil sensitivity profiles. Execution of the machine-executable instructions further causes the processor to receive coil sensitivity profiles. The initial magnetic resonance image is reconstructed from the measured k-space data and the coil sensitivity profiles. The intermediate image is generated by the compressed sensing data-consistency module using the de-noised magnetic resonance image, the measured k-space data, and the coil sensitivity profiles.

In another embodiment the medical instrument further comprises a magnetic resonance imaging system configured to acquire the measured k-space data from an imaging zone. The memory further contains pulse sequence commands configured for controlling the magnetic resonance imaging system to acquire the measured k-space data according to a compressed sensing magnetic resonance imaging protocol. Execution of the machine-executable instructions further causes the processor to acquire the measured k-space data by controlling the magnetic resonance imaging system with the pulse sequence commands.

In another embodiment execution of the machine-executable instructions further causes the processor to train the convolutional neural network by first receiving a fully sampled magnetic resonance image reconstructed from fully sampled k-space data. The fully sampled magnetic resonance image therefore does not have any artefacts due to insufficient sampling. Execution of the machine-executable instructions further causes the processor to receive training k-space data. The training k-space data is a subset of the sampled k-space data. The fully sampled k-space data may be used to generate the training k-space data.

This may be achieved by selecting a portion of the sampled k-space data. This then simulates the acquisition of k-space data when there is no full sampling. Execution of the machine-executable instructions further causes the processor to reconstruct an initial training image from the training k-space data. Execution of the machine-executable instructions further causes the processor to set the initial training magnetic resonance image as the input training magnetic resonance image.

Execution of the machine-executable instructions further causes the processor to train the convolutional neural network by iteratively generating an intermediate training magnetic resonance image and a de-noised training image by repeating the following steps the predetermined number of times. These steps include receiving a de-noised training magnetic resonance image from the convolutional neural network in response to inputting the input training magnetic resonance image into the convolutional neural network. The second step is then to receive the intermediate training image from the compressed sensing data-consistency module in response to inputting the de-noised training magnetic resonance image and the training k-space data. The iteration then repeats by using the intermediate training image as the new input training magnetic resonance image.

At the end of the iterative process either the de-noised training magnetic resonance image or the intermediate training image may be used for training. Execution of the machine-executable instructions further causes the processor to provide the intermediate training magnetic resonance image or the de-noised training magnetic resonance image as a reconstructed training image after the iterative steps are complete. Execution of the machine-executable instructions further causes the processor to calculate a loss function from the training magnetic resonance image and the fully sampled magnetic resonance image.

Execution of the machine-executable instructions further causes the processor to train the convolutional neural network by iteratively back propagating the loss function through the compressed sensing data-consistency module and the convolutional neural network. This may be done in an iterative process. The compressed sensing data-consistency module uses differentiable functions also and therefore the training may be back propagated through the compressed sensing data-consistency module.

This training can be done in several different ways. In one example there is a single convolutional neural network that is used. In each iterative process of the back propagation the convolutional neural network is trained. In another example for each step of the iteration there is a separate convolutional neural network. For example, the first iteration will have a convolutional neural network that is always used for the first iteration and then separate convolutional neural networks that are used for that specific subsequent iteration.

The training may also be performed in different manners. For example, to make a very specialized system images of a particular anatomy or type may always be used. This may result in a convolutional neural network that is highly trained for specific types of magnetic resonance imaging. In other examples a variety of images for different scan types as well as for different regions of anatomy may be used and a convolutional neural network which may be used in general for reconstructing compressed sensing images may be constructed.

In another embodiment the memory contains a single instance of the convolutional neural network used for each iterative generation of the intermediate magnetic resonance image. As was described above during training the same convolutional neural network may be used for each iteration during back propagation.

In another embodiment the memory contains a distinct instance of the convolutional neural network for each iterative generation of the intermediate magnetic resonance image. In this example the distinct instance of the convolutional neural network are trained separately and for specific iterations. This may result in a larger degree of training but may in some instances result in a compressed sensing method which operates and provides higher quality images.

In another embodiment the invention provides for a method of providing a reconstructed magnetic resonance image using a convolutional neural network, and a compressed sensing data-consistency module. The convolutional neural network is configured to output a de-noised magnetic resonance image in response to inputting an input magnetic resonance image. The convolutional neural network is a multi-scale deep neural network. The convolutional neural network comprises a first portion implementing a sparsifying transform. The compressed sensing data-consistency module is configured to generate an intermediate image by increasing consistency of the de-noised magnetic resonance image with the measured k-space values or data.

The method comprises receiving the measured k-space data. The method further comprises reconstructing an initial magnetic resonance image from the measured k-space data. The method further comprises setting the initial magnetic resonance image as the input magnetic resonance image. The method further comprises iteratively generating the intermediate magnetic resonance image and the de-noised magnetic resonance image by repeating the following steps a predetermined number of times: receiving the de-noised magnetic resonance image from the convolutional neural network in response to inputting the input magnetic resonance image into the convolutional neural network.

The iterative process also comprises receiving the intermediate image from the compressed sensing data-consistency module in response to inputting the de-noised magnetic resonance image and the measured k-space data. The method further comprises providing the intermediate magnetic resonance image or the de-noised magnetic resonance image as a reconstructed magnetic resonance image after the iterative steps are complete.

In another aspect the invention provides for a computer program product comprising machine-executable instructions, a convolutional neural network, and a compressed sensing data-consistency module. The convolutional neural network is configured to output a de-noised magnetic resonance image in response to inputting an input magnetic resonance image. The convolutional neural network is a multi-scale deep neural network. The convolutional neural network comprises a first portion implementing a sparsifying transform. The compressed sensing data-consistency module is configured to generate an intermediate image by increasing consistency of the de-noised magnetic resonance image with measured k-space data or values.

Execution of the machine-executable instructions further causes the processor to receive the measured k-space data. Execution of the machine-executable instructions further causes the processor to reconstruct an initial magnetic resonance image from the measured k-space data. Execution of the machine-executable instructions further causes the processor to set the initial magnetic resonance image as the input magnetic resonance image. Execution of the machine-executable instructions further causes the processor to iteratively generate the intermediate magnetic resonance image and the de-noised magnetic resonance image by repeating the following steps a predetermined number of times: the first step is to receive the de-noised magnetic resonance image from the convolutional neural network in response to inputting the input magnetic resonance image into the convolutional neural network.

Another iterative step is to receive the intermediate image from the compressed sensing data-consistency module in response to inputting the de-noised magnetic resonance image and the measured k-space data. In the next loop of the iteration the intermediate image is then used as the new input magnetic resonance image and is then input into the convolutional neural network. Execution of the machine-executable instructions further causes the processor to provide the intermediate magnetic resonance image or the de-noised magnetic resonance image as a reconstructed magnetic resonance image after the iterative steps are complete.

It is understood that one or more of the aforementioned embodiments of the invention may be combined as long as the combined embodiments are not mutually exclusive.

As will be appreciated by one skilled in the art, aspects of the present invention may be embodied as an apparatus, method or computer program product. Accordingly, aspects of the present invention may take the form of an entirely hardware embodiment, an entirely software embodiment (including firmware, resident software, microcode, etc.) or an embodiment combining software and hardware aspects that may all generally be referred to herein as a "circuit," "module" or "system." Furthermore, aspects of the present invention may take the form of a computer program product embodied in one or more computer readable medium(s) having computer executable code embodied thereon.

Any combination of one or more computer readable medium(s) maybe utilized. The computer readable medium may be a computer readable signal medium or a computer readable storage medium. A 'computer-readable storage medium' as used herein encompasses any tangible storage medium which may store instructions which are executable by a processor of a computing device. The computer-readable storage medium may be referred to as a computer-readable non-transitory storage medium. The computer-readable storage medium may also be referred to as a tangible computer readable medium. In some embodiments, a computer-readable storage medium may also be able to store data which is able to be accessed by the processor of the computing device. Examples of computer-readable storage media include, but are not limited to: a floppy disk, a magnetic hard disk drive, a solid state hard disk, flash memory, a USB thumb drive, Random Access Memory (RAM), Read Only Memory (ROM), an optical disk, a magneto-optical disk, and the register file of the processor. Examples of optical disks include Compact Disks (CD) and Digital Versatile Disks (DVD), for example CD-ROM, CD-RW, CD-R, DVD-ROM, DVD-RW, or DVD-R disks. The term computer readable-storage medium also refers to various types of recording media capable of being accessed by the computer device via a network or communication link. For example a data may be retrieved over a modem, over the internet, or over a local area network. Computer executable code embodied on a computer readable medium may be transmitted using any appropriate medium, including but not limited to wireless, wire line, optical fiber cable, RF, etc., or any suitable combination of the foregoing.

A computer readable signal medium may include a propagated data signal with computer executable code embodied therein, for example, in baseband or as part of a carrier wave. Such a propagated signal may take any of a variety of forms, including, but not limited to, electro-magnetic, optical, or any suitable combination thereof. A computer readable signal medium may be any computer readable medium that is not a computer readable storage medium and that can communicate, propagate, or transport a program for use by or in connection with an instruction execution system, apparatus, or device.

'Computer memory' or 'memory' is an example of a computer-readable storage medium. Computer memory is any memory which is directly accessible to a processor. 'Computer storage' or 'storage' is a further example of a computer-readable storage medium. Computer storage is any non-volatile computer-readable storage medium. In some embodiments computer storage may also be computer memory or vice versa.

A 'processor' as used herein encompasses an electronic component which is able to execute a program or machine executable instruction or computer executable code. References to the computing device comprising "a processor" should be interpreted as possibly containing more than one processor or processing core. The processor may for instance be a multi-core processor. A processor may also refer to a collection of processors within a single computer system or distributed amongst multiple computer systems. The term computing device should also be interpreted to possibly refer to a collection or network of computing devices each comprising a processor or processors. The computer executable code may be executed by multiple processors that may be within the same computing device or which may even be distributed across multiple computing devices.

Computer executable code may comprise machine executable instructions or a program which causes a processor to perform an aspect of the present invention. Computer executable code for carrying out operations for aspects of the present invention may be written in any combination of one or more programming languages, including an object oriented programming language such as Java, Smalltalk, C++ or the like and conventional procedural programming languages, such as the "C" programming language or similar programming languages and compiled into machine executable instructions. In some instances the computer executable code may be in the form of a high level language or in a pre-compiled form and be used in conjunction with an interpreter which generates the machine executable instructions on the fly.

The computer executable code may execute entirely on the user's computer, partly on the user's computer, as a stand-alone software package, partly on the user's computer and partly on a remote computer or entirely on the remote computer or server. In the latter scenario, the remote computer may be connected to the user's computer through any type of network, including a local area network (LAN) or a wide area network (WAN), or the connection may be made to an external computer (for example, through the Internet using an Internet Service Provider).

Aspects of the present invention are described with reference to flowchart illustrations and/or layer diagrams of methods, apparatus (systems) and computer program products according to embodiments of the invention. It is understood that each layer or a portion of the layers of the flowchart, illustrations, and/or layer diagrams, can be implemented by computer program instructions in form of computer executable code when applicable. It is further under stood that, when not mutually exclusive, combinations of layers in different flowcharts, illustrations, and/or layer diagrams may be combined. These computer program instructions may be provided to a processor of a general purpose computer, special purpose computer, or other programmable data processing apparatus to produce a machine, such that the instructions, which execute via the processor of the computer or other programmable data processing apparatus, create means for implementing the functions/acts specified in the flowchart and/or layer diagram layer or layers.

These computer program instructions may also be stored in a computer readable medium that can direct a computer, other programmable data processing apparatus, or other devices to function in a particular manner, such that the instructions stored in the computer readable medium produce an article of manufacture including instructions which implement the function/act specified in the flowchart and/or layer diagram layer or layers.

The computer program instructions may also be loaded onto a computer, other programmable data processing apparatus, or other devices to cause a series of operational steps to be performed on the computer, other programmable apparatus or other devices to produce a computer implemented process such that the instructions which execute on the computer or other programmable apparatus provide processes for implementing the functions/acts specified in the flowchart and/or layer diagram layer or layers.

A 'user interface' as used herein is an interface which allows a user or operator to interact with a computer or computer system. A 'user interface' may also be referred to as a 'human interface device.' A user interface may provide information or data to the operator and/or receive information or data from the operator. A user interface may enable input from an operator to be received by the computer and may provide output to the user from the computer. In other words, the user interface may allow an operator to control or manipulate a computer and the interface may allow the computer indicate the effects of the operator's control or manipulation. The display of data or information on a display or a graphical user interface is an example of providing information to an operator. The receiving of data through a keyboard, mouse, trackball, touchpad, pointing stick, graphics tablet, joystick, gamepad, webcam, headset, pedals, wired glove, remote control, and accelerometer are all examples of user interface components which enable the receiving of information or data from an operator.

A 'hardware interface' as used herein encompasses an interface which enables the processor of a computer system to interact with and/or control an external computing device and/or apparatus. A hardware interface may allow a processor to send control signals or instructions to an external computing device and/or apparatus. A hardware interface may also enable a processor to exchange data with an external computing device and/or apparatus. Examples of a hardware interface include, but are not limited to: a universal serial bus, IEEE 1394 port, parallel port, IEEE 1284 port, serial port, RS-232 port, IEEE-488 port, Bluetooth connection, Wireless local area network connection, TCP/IP connection, Ethernet connection, control voltage interface, MIDI interface, analog input interface, and digital input interface.

A 'display' or 'display device' as used herein encompasses an output device or a user interface adapted for displaying images or data. A display may output visual, audio, and or tactile data. Examples of a display include, but are not limited to: a computer monitor, a television screen, a touch screen, tactile electronic display, Braille screen, Cathode ray tube (CRT), Storage tube, Bi-stable display, Electronic paper, Vector display, Flat panel display, Vacuum fluorescent display (VF), Light-emitting diode (LED) displays, Electroluminescent display (ELD), Plasma display panels (PDP), Liquid crystal display (LCD), Organic light-emitting diode displays (OLED), a projector, and Head-mounted display.

k-space data is defined herein as being the recorded measurements of radio frequency signals emitted by atomic spins using the antenna of a Magnetic resonance apparatus during a magnetic resonance imaging scan. k-space data is an example of medical image data. A Magnetic Resonance Imaging (MRI) image or MR image is defined herein as being the reconstructed two-, three-, or four- dimensional visualization of anatomic data contained within the k-space data. This visualization can be performed using a computer.

BRIEF DESCRIPTION OF THE DRAWINGS

In the following preferred embodiments of the invention will be described, by way of example only, and with reference to the drawings in which:

Fig. 1 illustrates an example of a medical instrument;
Fig. 2 illustrates an example method of operating the medical instrument of Fig. 1 or Fig. 3;
Fig. 3 illustrates a further example of a medical instrument;
Fig. 4 illustrates a method of training a convolutional neural network;
Fig. 5 illustrates a method of compressed sensing for magnetic resonance imaging;
Fig. 6 illustrates an example of a neural network;
Fig. 7 illustrates a further example of a neural network;
Fig. 8 illustrates a further example of a neural network;
Fig. 9 shows an example of a zero-filled reconstruction of a magnetic resonance image;
Fig. 10 shows a compressed sensing reconstruction according to a method described herein for the same under sampled k-space data as in Fig. 9; and
Fig. 11 shows a magnetic resonance imaging reconstruction from fully sampled k-space data.

DETAILED DESCRIPTION OF THE EMBODIMENTS

Like numbered elements in these figures are either equivalent elements or perform the same function. Elements which have been discussed previously will not necessarily be discussed in later figures if the function is equivalent.

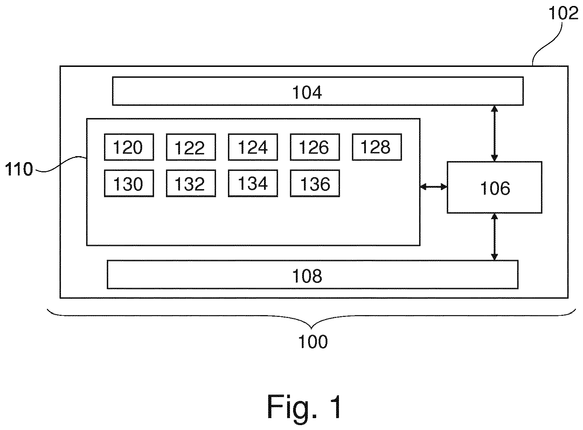

Fig. 1 illustrates an example of a medical instrument 100. The medical instrument 100 comprises a computer 102 that has a processor 106 in communication with a hardware interface 104, a user interface 108, and a memory 110. The medical instrument 100 in Fig. 1 may for example be integrated into a magnetic resonance imaging system and it may also be operated as a standalone processing unit or workstation. For example, the computer 102 could be a workstation in a hospital which is used for reconstructing images and/or by radiologists for examining magnetic resonance images. The computer 102 may also be a virtual machine or other machine which is located in the cloud or at a remote location and used for computationally intensive tasks.

The hardware interface 104 may for example enable the processor 106 to communicate via network interface with other computer systems. The hardware interface 104 may also enable the processor 106 to control and operate other components of the medical imaging system 100.

The memory 110 is shown as containing machine-executable instructions 120. The machine-executable instructions 120 enable the processor 106 to control other components via the hardware interface 104 if they are present.

Additionally, the machine-executable instructions 120 enable the processor 106 to perform various data processing and computational tasks. The memory 122 is shown as further containing a convolutional neural network. The convolutional neural network is a multi-scale deep neural network. Deep neural networks comprise skip connections and by multi-scale the neural network uses various pooling layers and upsampling layers. The image can then be processed on several different scales.

This may improve its ability to remove noise from magnetic resonance images. The convolutional neural network also at least comprises a first portion. This first portion implements a sparsifying transform. The memory 110 is further shown as containing a compressed sensing data-consistency module 124. In compressed sensing an iterative process is performed where noise is removed from an image and then a data consistency module modifies this de-noised image so that it is more consistent with the original data. This allows an iterative process to gradually recover an image that is not fully sampled.

The memory 110 is further shown as containing measured k-space data 126. The memory is then further shown as containing an initial magnetic resonance image 128 that was reconstructed from the measured k-space data 126. The system in Fig. 1 is used to iteratively generate a reconstructed magnetic resonance image 136. The reconstructed magnetic resonance image 136 is shown as being in the memory 110.

To construct the reconstructed magnetic resonance image 136 the measured k-space data 126 is first used to reconstruct an initial magnetic resonance image 128. The initial magnetic resonance image 128 is then set as the input magnetic resonance image 130. The input magnetic resonance image 130 is then input into the convolutional neural network 122 to provide the de-noised magnetic resonance image 132. The de-noised magnetic resonance image 132 is then input into the compressed sensing data-consistency module 124 to provide the intermediate image 134. In the next loop of the iteration the intermediate image is set as the input image and then input into the convolutional neural network 122.

This process then repeats a set number of times. The loop further calculations can be broken when either the de-noised magnetic resonance image 132 is calculated a predetermined number of times or when the intermediate image 134 is calculated a predetermined number of times. After iterations are complete the de-noised magnetic resonance image 132 or the intermediate image 134 is provided as the reconstructed magnetic resonance image.

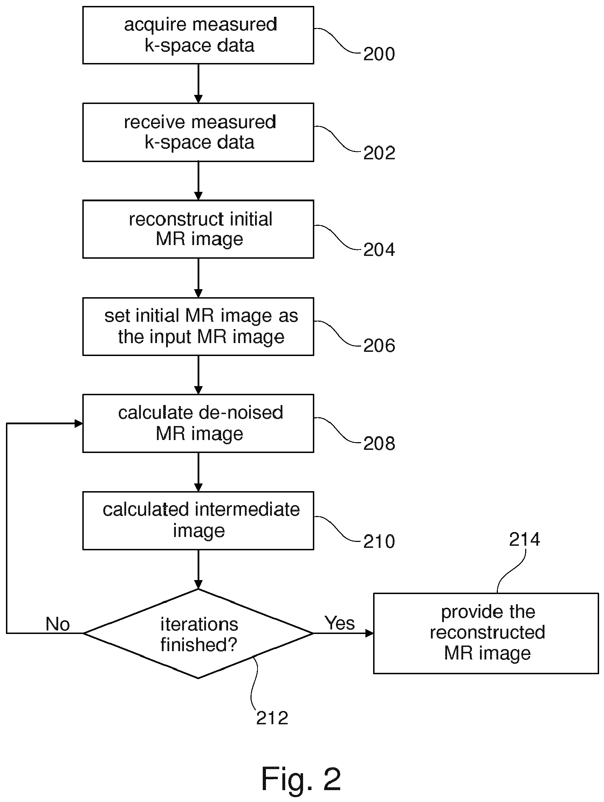

Fig. 2 shows a flowchart which illustrates a method of operating the medical instrument 100 of Fig. 1. In step 200 the method starts by controlling a magnetic resonance imaging system with pulse sequence commands to acquire measured k-space data. The pulse sequence commands would be configured for controlling the magnetic resonance imaging system according to a compressed sensing magnetic resonance imaging protocol. In some examples step 200 is optional. After step 200 the method proceeds to step 202. In step 202 the measured k-space data 126 is received.

Next in step 204 the initial magnetic resonance image 128 is reconstructed from the measured k-space data 126. Then in step 206 the initial magnetic resonance image 128 is set as the input magnetic resonance image 130. The method then enters the iterative compressed sensing loop to recover the reconstructed magnetic resonance image 136. In this iterative process firstly the de-noised magnetic resonance image 132 is calculated by inputting the input magnetic resonance image 130 into the convolutional neural network 122. This results in outputting the de-noised magnetic resonance image 132. The de-noised magnetic resonance image 132 is then input into the compressed sensing data-consistency module 124.

In response the intermediate image 134 is provided by the compressed sensing data-consistency module. Box 212 is a decision box; it indicates are the iterations finished. If the answer is "no" then the method proceeds back to step 208. If the answer to the questions is "yes" the method proceeds to step 214 and the reconstructed magnetic resonance image 136 is provided by either taking the intermediate image 134 or the de-noised magnetic resonance image 132. The decision box 212 is shown as being after step 210. However, the loop can be broken after step 208 is performed a predetermined number of times or step 210 is performed a predetermined number of times.

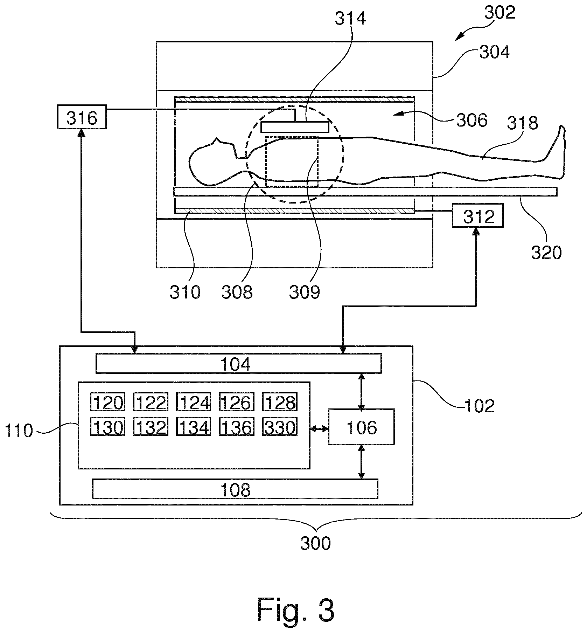

Fig. 3 illustrates a further example of a medical instrument 300. The medical instrument 300 comprises the computer system 102 of Fig. 1. The medical instrument 300 is shown as additionally comprising a magnetic resonance imaging system 302.

The magnetic resonance imaging system 302 comprises a magnet 304. The magnet 304 is a superconducting cylindrical type magnet with a bore 306 through it. The use of different types of magnets is also possible; for instance it is also possible to use both a split cylindrical magnet and a so called open magnet. A split cylindrical magnet is similar to a standard cylindrical magnet, except that the cryostat has been split into two sections to allow access to the iso-plane of the magnet, such magnets may for instance be used in conjunction with charged particle beam therapy. An open magnet has two magnet sections, one above the other with a space in-between that is large enough to receive a subject: the arrangement of the two sections area similar to that of a Helmholtz coil. Open magnets are popular, because the subject is less confined. Inside the cryostat of the cylindrical magnet there is a collection of superconducting coils.

Within the bore 306 of the cylindrical magnet 304 there is an imaging zone 308 where the magnetic field is strong and uniform enough to perform magnetic resonance imaging. A region of interest 309 is shown within the imaging zone 308. The magnetic resonance data that is acquired typically acquried for the region of interest. A subject 318 is shown as being supported by a subject support 320 such that at least a portion of the subject 318 is within the imaging zone 308 and the region of interest 309.

Within the bore 306 of the magnet there is also a set of magnetic field gradient coils 310 which is used for acquisition of preliminary magnetic resonance data to spatially encode magnetic spins within the imaging zone 308 of the magnet 304. The magnetic field gradient coils 310 connected to a magnetic field gradient coil power supply 312. The magnetic field gradient coils 310 are intended to be representative. Typically magnetic field gradient coils 310 contain three separate sets of coils for spatially encoding in three orthogonal spatial directions. A magnetic field gradient power supply supplies current to the magnetic field gradient coils. The current supplied to the magnetic field gradient coils 310 is controlled as a function of time and may be ramped or pulsed.

Adjacent to the imaging zone 308 is a radio-frequency coil 314 for manipulating the orientations of magnetic spins within the imaging zone 308 and for receiving radio transmissions from spins also within the imaging zone 308. The radio frequency antenna may contain multiple coil elements. The radio frequency antenna may also be referred to as a channel or antenna. The radio-frequency coil 314 is connected to a radio frequency transceiver 316. The radio-frequency coil 314 and radio frequency transceiver 316 may be replaced by separate transmit and receive coils and a separate transmitter and receiver. It is understood that the radio-frequency coil 314 and the radio frequency transceiver 316 are representative. The radio-frequency coil 314 is intended to also represent a dedicated transmit antenna and a dedicated receive antenna. Likewise the transceiver 316 may also represent a separate transmitter and receivers. The radio-frequency coil 314 may also have multiple receive/transmit elements and the radio frequency transceiver 316 may have multiple receive/transmit channels. For example if a parallel imaging technique such as SENSE is performed, the radio-frequency could 314 will have multiple coil elements.

The transceiver 316 and the gradient controller 312 are shown as being connected to the hardware interface 106 of a computer system 102.

The memory 110 is further shown as containing pulse sequence commands which enable the processor 106 to control the magnetic resonance imaging system 302 to a compressed sensing magnetic resonance imaging protocol. The method illustrated in Fig. 2 may therefore be used to control the magnetic resonance imaging system 302 in step 200.

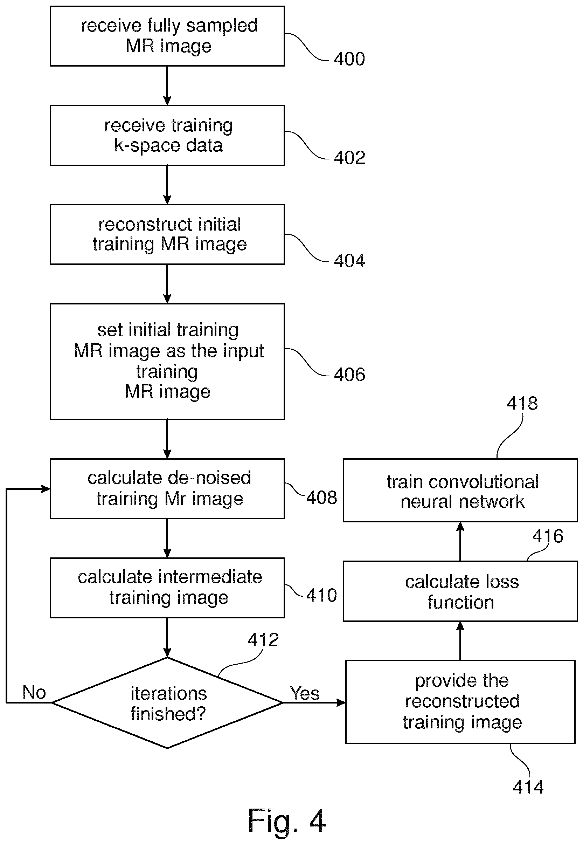

Fig. 4 shows a flowchart which illustrates a method of training the convolutional neural network 122. For example, the processor 106 may be programmed to perform the method illustrated in Fig. 4. First in step 400 a fully sampled magnetic resonance image is received. This image has been reconstructed from fully sampled k-space data. Next in step 402 training k-space data is received. The training k-space data is a subset of the sampled k-space data. For example, a portion of the fully sampled k-space data maybe selected to provide the sampled k-space data. This essentially simulates acquiring k-space data in a not fully sampled manner. It could be used for example to simulate acquiring magnetic resonance data to a compressed sensing magnetic resonance imaging protocol.

Next in step 404 an initial training image is reconstructed from the training k-space data. Then in step 406 the initial training magnetic resonance image is set as the input training magnetic resonance image. The method then proceeds to an iterative process in steps 408 and 410. This is used to iteratively generate a reconstructed training image. In step 408 a de-noised training image is received from the convolutional neural network in response to inputting the input training magnetic resonance image into the convolutional neural network 122. Then in step 410 the intermediate training magnetic resonance image is received from the compressed sensing data-consistency module in response to inputting the de-noised training magnetic resonance image and the training k-space data. Step 412 is a decision box and asks the questions "are the iterations finished?"

If the answer is "yes," then the method proceeds to step 414. If not, the method proceeds back to step 408. To perform step 408 the intermediate training image is then used as the new input image and steps 408 and 410 repeat. Box 412 is shown as being after step box 410, however, the method illustrated in Fig. 4 can be stopped and then proceed to box 414 after box 408 or 410 has been performed a predetermined number of times. When the method proceeds to step 414 the reconstructed training image is provided after the iterative steps are complete by using either the intermediate training magnetic resonance image or the de-noised training magnetic resonance image.

Next in step 416 a loss function is calculated from the training magnetic resonance image and the fully sampled magnetic resonance image. Then in step 418 the convolutional neural network 122 is trained by iteratively back propagating the loss function through the compressed sensing data-consistency module and the convolutional neural network. Normally in back propagation the data is only back propagated through the neural network. However, it is also possible to back propagate the data through the compressed sensing data consistency module. This may provide for a more effective filtering convolutional neural network.

One of MRI's main disadvantages is the long acquisition time, which is inherent to the way data is sampled in k-space and to physiological restrictions (i.e., peripheral nerve stimulation). Parallel imaging (PI) and compressed sensing (CS) have allowed to shorten acquisition times by using information from multiple coils and prior knowledge about image properties, at the cost of more computation during image reconstruction.

Lately, deep neural networks mimicking iterative CS image reconstruction have been developed with the goal to increase both final image quality and reconstruction speed. The expected image quality improvement comes from the fact that the networks are trained on MR data and should therefore have better prior knowledge of the underlying image distribution than traditional CS algorithms, which rely on very general assumptions verified by most natural images. To best capture this underlying distribution with a reduced number of parameters, it is important that the network has an adapted architecture.

Examples provide a neural network architecture that, by capturing multiscale properties of the prior image distribution, provides high quality of the reconstructed image with large subsampling rate. This result is achieved by introducing a learned multiscale regularization and filtering, thus leveraging successful concepts of image segmentation networks and integrating them into a CS reconstruction network.

As mentioned above, parallel imaging (PI) and compressed sensing (CS) have allowed to shorten acquisition times by acquiring only a fraction of the k-space that would in general be required to obtain a target image resolution. This lack of measurements is compensated by using information from multiple coils and by including prior knowledge about image properties into the reconstruction algorithm, at the cost of more computation.

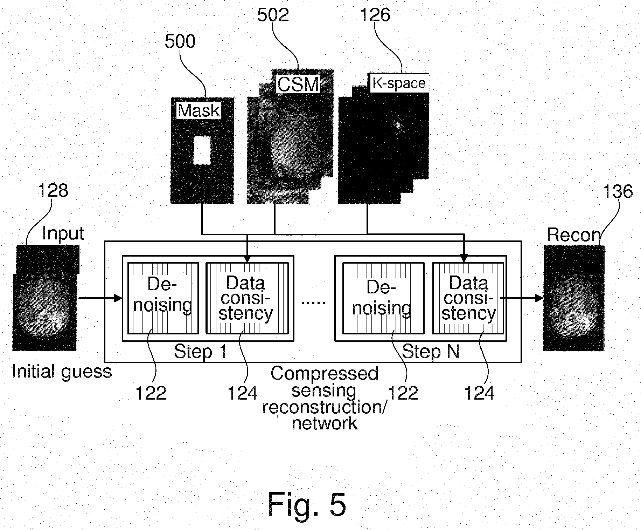

Fig. 5 illustrates functionally one method of generating the reconstructed magnetic resonance image 136. The method starts with an initial guess which is the initial magnetic resonance image 128. This is then inserted into a compressed sensing reconstruction network which comprises the convolutional neural network 122 that is used for de-noising and the compressed sensing data-consistency module 124 which provides data consistency. The measured k-space data 126 is also input into the compressed sensing data-consistency module 124 in each iteration. Optionally, a k-space map 500 and coil sensitivity profiles 502 may also be used.

In Fig. 5, image quality improvement comes from the fact that the convolutional neural networks are trained on MR data and should therefore have better prior knowledge of the underlying image distribution than traditional CS algorithms, which rely on very general assumptions verified by most natural images. In general, these networks mimic iterative CS algorithms that alternate data consistency steps (in k-space, using the undersampling mask and the coil sensitivity maps (CSM)) and denoising steps (in image space). During training, the network learns parameters for the denoising step.

The performance of a CS reconstruction algorithm crucially depends on the performance of the employed denoising on the typical images to be reconstructed. On very structured images such as MR images, local structures vary depending on their extended local environment (e.g. on which type of tissue they are in). Denoisers capable of grasping such information will therefore be more successful than denoisers acting only on very small scales. Image classification and segmentation networks have shown that using down-sampling layers, such as max-pooling layers, and up-sampling layers allows to efficiently increase a network's receptive field and to detect and make use of the local image information on multiple scales.

Examples may provide a convolutional neural network architecture that aims at capturing the multiscale nature of the image distribution. Examples may achieve better image quality for high subsampling rates, hence enabling faster acquisition time. Moreover, examples may provide for better generalization than state-of-the-art of such learned CS reconstruction networks.

Examples may provide for denoising steps of a CS reconstruction network using a convolutional neural network such that they act on multiple scales. This can be achieved in some examples as follows: Each denoising step is implemented as a combination of a 1) multiscale deep neural network implementing a sparsifying transform, a 2) learnable thresholding function and 3) a second multiscale deep neural network implementing the inversion of the sparsifying transform.

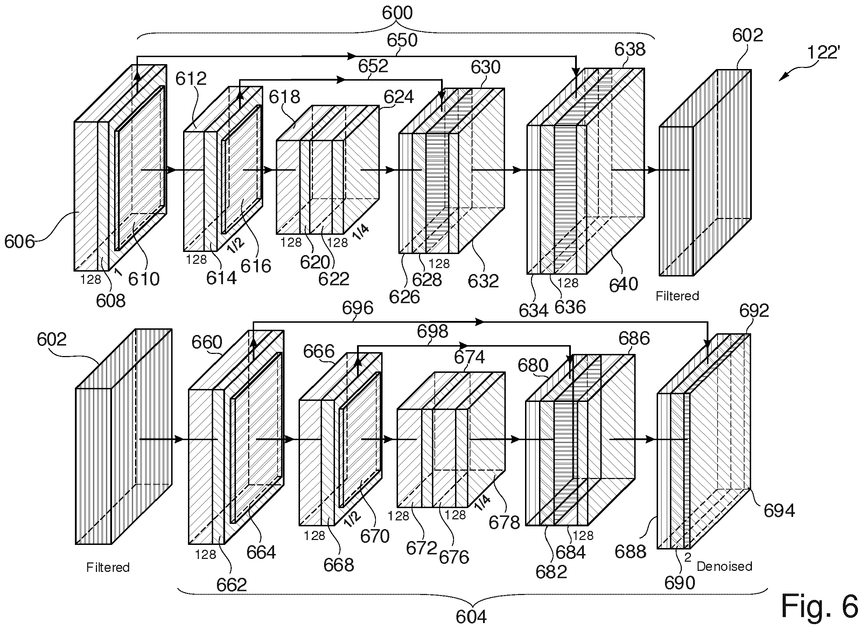

Fig. 6 illustrates an example of a convolutional neural network 122' that may be used as the convolutional neural network for generating the de-noised training magnetic resonance image. The convolutional neural network comprises a first portion 600, a trained filter layer 602 and a second portion 604. The first portion 600 is used to generate or implement a sparsifying transform. The trained filter layer 602 can then threshold the sparsified representation of the input image and then the second portion 604 then reconstructs the de-noised magnetic resonance image 132.

The input to the convolutional neural network 122' is a first convolutional layer 608 followed by a first rectifier unit layer 608. Next there is a first pooling layer 610 which reduces the dimensionality of the image. After the first pooling layer 610 is a second convolutional layer 612 and a second rectifier unit layer 614. After the second rectifier unit layer 614 is a second pooling layer 616 which again reduces the dimensionality further. After the second pooling layer 616 is a first intermediate convolutional layer 618 and first intermediate rectifier unit layer 620. This is followed by a second intermediate convolutional layer 622 and second intermediate rectifier unit layer 624. In some examples the second intermediate convolutional layer and second intermediate rectifier unit layer may be left out. In other examples there may be additional layers of convolutional layers and rectifier units added on after the second intermediate rectifier unit layer 624. In this example after the second intermediate rectifier unit layer 624 is a first upsampling layer 626 that again increases the dimensionality of the image.

The first upsampling layer 626 is connected to a first concatenation layer 628. After the first concatenation layer 628 there is a third convolutional layer 630 and third rectifier unit layer 632. This is then input into a second upsampling layer 634. The second upsampling layer 634 is connected then to a second concatenation layer 636. The second concatenation layer is connected to the fourth convolutional layer 638 which is then input into a fourth rectifier unit layer 640.

There is a skip connection between the first rectifier unit layer 608 and the second concatenation layer 636. There is a second skip connection 652 between the second rectifier unit layer 614 and the first concatenation layer 628. This completes the first portion 600 of the convolutional neural network 122' in this example. The output of the fourth rectifier unit layer 640 is then input into the trained filter layer 602. The same trained filter layer 602 is repeated on the bottom half of the Fig. in Fig. 6: There is only one trained filter layer 602 in this diagram. The trained filter layer 602 is then input into the fifth convolutional layer 600 which then goes to the fifth rectifier unit layer 662. The fifth rectifier unit layer 662 is connected to the third pooling layer 664 which again reduces the dimensionality.

The third pooling layer 664 is connected to the sixth convolutional layer 666 which is then input into the sixth rectifier unit layer 668. The sixth rectifier unit layer 668 is then input into the fourth pooling layer 670. The fourth pooling layer 670 is input into the third intermediate convolutional layer 672 and third intermediate rectifier unit layer 674. The third intermediate rectifier unit layer 674 is input into the fourth intermediate convolutional layer 676 and fourth intermediate rectifier unit layer 678. The fourth intermediate rectifier unit layer 678 is input into the third upsampling layer 680. The third upsampling layer 680 is input into the third concatenation layer 682. The third concatenation layer 682 is input into the seventh convolutional layer 684.

The seventh convolutional layer 684 is input into the seventh rectifier unit layer 686. The seventh rectifier unit layer 686 is input into the fourth upsampling layer 688. The fourth upsampling layer 688 is input into the fourth concatenation layer 690. The fourth concatenation layer 690 is input into the eighth convolutional layer 692 which then goes to the eighth rectifier unit layer 694. The eighth rectifier unit layer 694 in this example is the output of the convolutional neural network 122'. There is a third skip connection 696 between the fifth rectifier unit layer 662 and the fourth concatenation layer 690. There is a fourth skip connection 698 between the sixth rectifier unit layer 668 and the third concatenation layer 682.

The convolutional neural network 122' in Fig. 6 the first portion 600 and the second portion 604 are symmetric. The convolutional neural network 122' provides excellent performance in de-noising magnetic resonance images.

Fig.6 presents an example of the proposed approach structure of a multiscale denoiser implemented as a convolutional neural network. At the top of the image, a neural network implements the sparsification of the signal. The rectifier unit layers may be parametric rectifier units in some examples. The pooling layers may be max pooling blocks or layers in some examples. The pooling layers may also be other types of pooling layers such as average or mean pooling blocks.

Concatenation layers 628, 636, 682, 690 are used to implement the skip connections 650, 652, 696, 698. By a combination of pooling layers and convolution layers, a socalled information bottleneck is created. This encourages the deep neural network to learn, if needed, high-level representation of the data. The output of this network is a high-dimensional image, for example in Fig. 6 it consists of 128 channels.

This high-dimensional image is then filtered, see block or layer 602 in Fig. 6. Each channel is filtered with a soft thresholding function. The thresholds are free parameters that are learned during the training of the network. Finally, the filtered high-dimensional signal is transformed back in the denoised image. To this regard, the inversion of the sparsifying transform is computed by a second multiscale deep neural network, see the bottom of Fig. 6. This network shares a similar design to one that sparsify the signal; it consists of several max-pooling blocks and an information bottleneck.

Fig. 6. illustrates an example of the structure of a multiscale denoiser. On the upper side, the sparsification, of the signal is performed by a multiscale architecture. The high-dimensional signal is filtered, in purple, with a soft-thresholding function. The threshold is different for each of the channels, 128 in this case, and learned together with the network parameters. At the bottom, the high-dimensional signal is converted in the denoised image.

During training, a loss function is used to enforce that, excluding the filtering, the second architecture compute the inverse of the function computed by the first. The complete network architecture is obtained by replacing the denoising blocks in Fig. 5 with the networks presented in Fig. 6. The loss function used for training the network consists of two terms; 1) image reconstruction and 2) network inversion. The image reconstruction enforces the networks to learn the transformation that provides better reconstruction performance, i.e., better signal reconstruction under a high undersampling rate. The 2) network inversion term

enforces the inversion of the two modules presented in Fig. 6, i.e., I(F(image)) = image. This second term improves the generalization of the technique, as it reduces the chance of introducing undesired artifacts by the network. The network inversion term is weighted by the alpha parameter, which is selected to be arbitrarily low. The total loss is the sum of the loss function in Eq. 1 below for each intermediate step of the unrolled reconstruction network:

$$Loss = \sum_{iter=0}^{N} Loss_{iter}^{Image} + \alpha Loss_{iter}^{Inversion}$$

$$Loss_{iter}^{Image} = MSE(I\left(T\big(F(image_{iter})\big)\right), target)$$

$$Loss_{iter}^{Inversion} = MSE(I\big(F(image_{iter})\big), image_{iter})$$

This enforces the network to learn the parameters in the most compact way as possible, i.e., requiring the lowest number of iterations that are needed for the reconstruction problem. Moreover, the learned functions are not constrained to be equal at different stages of the reconstruction. This allows the network to learn different denoisers that perform better at different stages of the reconstruction process.

Eq. 1 is a loss function which maybe used during training. The loss is divided in two components; the 1) image reconstruction term and the 2) network inversion term. The image reconstruction enforces the networks to learn the transformation that provides better reconstruction performance, i.e., better signal reconstruction under a high undersampling rate **F**, computes the sparsifying transform, T is the thresholding function while I computes the inversion of **F**. $image_{iter}$ is the input to the denoiser at iteration *iter*. The 2) network inversion term, enforces the inversion of the two modules presented in Fig. 2, i.e., $(F(image_{iter})) = image_{iter}$. This second term improves the generalization of the technique, as it reduces the chance of introducing undesired artifacts by the network. The network inversion term is weighted by the alpha parameter, which is selected to be arbitrarily low.

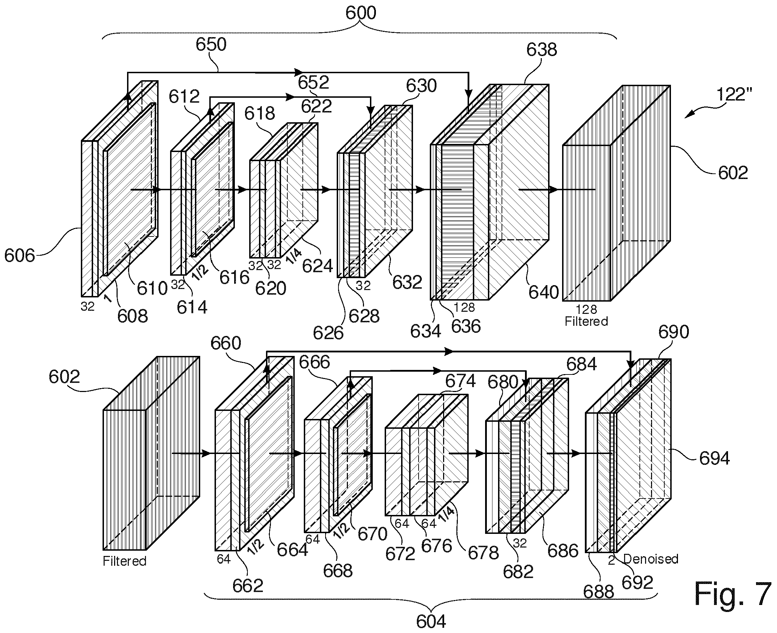

In order to improve the computational complexity and memory occupation of the proposed architecture, some examples also an asymmetric architecture, as presented in Fig. 7 below. In this case, the depth of the convolutional filters increases for the sparsifying transform, while it decreases for the network that implements the inversion. This solution allows for 1) a high-dimensional filtering space, 2) a multiscale representation of the data while 3) keeping reducing the number of network parameters to be learned. Besides the advantage of having a lower memory footprint and computational complexity, a reduction in the number of hyper parameters is also associated with improved generalization of the model The previously described multiscale denoising step can be combined in different ways with the data consistency step. Therefore, it is not limited to one of the existing schemes.

Fig. 7. In order to reduce computational complexity and GPU memory allocation, without affecting performance, an asymmetric architecture is used. The depth of the filter banks 602 are increased in the sparsifying architecture, while reduced for the inversion.

Fig. 7 shows an example which is similar to that in Fig. 6. In Fig. 7 the convolutional neural network 122" has the same layers as the convolutional neural network 122' in Fig. 6 however the first portion 600 and the second portion 604 are no longer symmetric. The asymmetric convolutional neural network 122" has the advantage that the computational resources required to operate the convolutional neural network 122" is reduced.

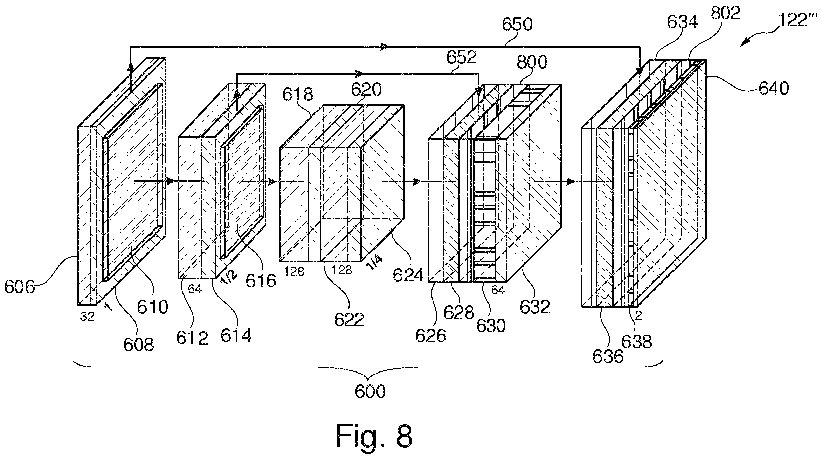

Fig. 8 illustrates a further example of a convolutional neural network 122''' that can be used to filter magnetic resonance images. In this example the convolutional neural network 122''' only comprises the first portion 600. In this example the structure of the layers in the first portion 600 is extremely similar to the first portion 600 as illustrated in Figs. 6 and 7. The first portion 600 in Fig. 8 comprises the same layers that the first portion 600 does in Figs. 6 and 7 there are however two additional layers. Between the first concatenation layer 628 and the third convolutional layer 630 there is a first trainable filter layer 800. Between the second concatenation layer 636 and the fourth convolutional layer 638 there is a second trainable filter layer 802. In this example the input the convolutional neural network 122''' is layer 608, the output of the convolutional neural network 122''' which outputs the de-noised magnetic resonance image 132 is layer 640.

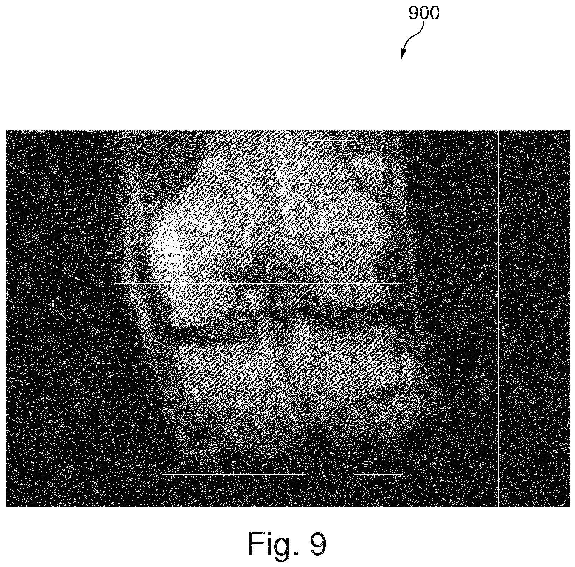

Figs. 9, 10 and 11 illustrate the efficiency and image quality achieved using the systems and methods described herein. Fig. 9 shows a reconstruction of a magnetic resonance image 900 that uses a 0-field reconstruction with an undersampling factor R=8.4. A zero filled reconstruction, i.e., where non acquired data is replaced by zeros is presented in Fig. 9.

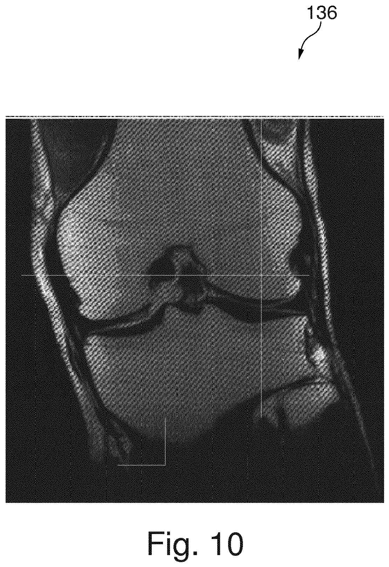

Fig. 10 shows an example using the same data according to the methods and systems described herein. Fig. 10 shows an example of a reconstructed magnetic resonance image 136 according to an example. An undersampling factor of R=8.4 is approximately double the value used in COMPRESSED-SENSE, allowing for a reduction for the time spent by the patient in the scanner of approximately 50%.

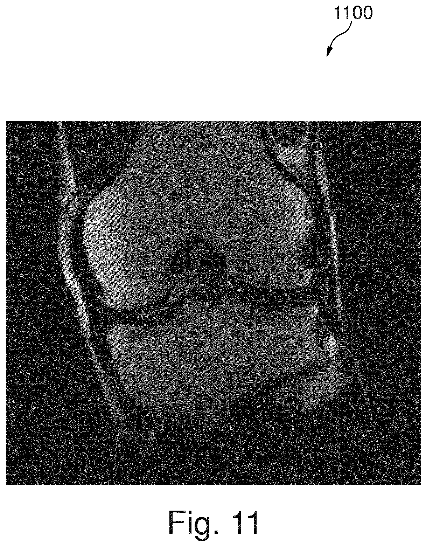

Fig. 11 shows an example of a fully sampled magnetic resonance image 1100. It can be seen by examining Figs. 10 and 11 that the image quality of Fig. 10 is comparable to the image 1100 shown in Fig. 11.

Here several examples of how to build a multiscale CS reconstruction network (convolutional neural network 122, 122', 122", 122"').

Example 1: One possibility is to use an unrolled scheme. The denoising step is modified such that it acts on multiple scales, as presented in the previous section. The training of the network is performed using a training dataset consisting of fully sampled data. From this fully sampled data, reference images are produced, as well as retrospectively undersampled k-spaces, that are given as input to the network, possibly along with side information such as coil sensitivity maps. The training of the network is done using an optimization algorithm such as SGD, Adam or RMSProp, using the mean squared error (MSE) between the reference image and the network's output as a loss function. Other loss functions could be used, such as the structural similarity (to be maximized), or loss functions calculated by a neural network pretrained to return a scalar that correlates well to a radiologist's perceptions of image quality. Additionally, the loss function includes a term that forces the inversion of the transform, as presented in the previous section.

Example 2: Another possibility is to use the same network structure as described in example 1 with the difference that the network's learned parameters are shared across all layers / unrolled iterations instead of being learned independently.

Example 3: Another possibility is to use a network such as describe in example 1 or 2 as the "generator" inside of a Generative Adversarial Network (GAN), in which the training of the generator and a discriminator are performed jointly. In such a setting, the discriminator could use a similar multiscale structure as the generator. After the joint training, only the generator is used during actual image reconstruction.

While the invention has been illustrated and described in detail in the drawings and foregoing description, such illustration and description are to be considered illustrative or exemplary and not restrictive; the invention is not limited to the disclosed embodiments.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. A single processor or other unit may fulfill the functions of several items recited in the claims. The mere fact that certain measures are recited in mutually different dependent claims does not indicate that a combination of these measured cannot be used to advantage. A computer program may be stored/distributed on a suitable medium, such as an optical storage medium or a solid-state medium supplied together with or as part of other hardware, but may also be distributed in other forms, such as via the Internet or other wired or wireless telecommunication systems. Any reference signs in the claims should not be construed as limiting the scope.

LIST OF REFERENCE NUMERALS

| | |
|---|---|
| 100 | medical instrumnet |
| 102 | computer |
| 104 | hardware interface |
| 106 | processor |
| 108 | user interface |
| 110 | memory |
| 120 | machine executable instructions |
| 122 | convolutional neural network |
| 122' | convolutional neural network |
| 122" | convolutional neural network |
| 122''' | convolutional neural network |
| 124 | compressed sensing data-consistency module |
| 126 | measured k-space data |
| 128 | initial magnetic resonance image |
| 130 | input magnetic resonance image |
| 132 | de-noised magnetic resonance image |
| 134 | intermediate image |
| 136 | reconstructed magnetic resonance image |
| 200 | acquire the measured k-space data by controlling the magnetic resonance imaging system with the pulse sequence commands |
| 202 | receive the measured k-space data |
| 204 | reconstruct an initial magnetic resonance image from the measured k-space data |
| 206 | set the initial magnetic resonance image as the input magnetic resonance image |

| 208 | receive the de-noised magnetic resonance image from the convolutional neural network in response to inputting the input magnetic resonance image into the convolutional neural network |
| 210 | receive the intermediate image from the compressed sensing data consistency module in response to inputting the denoised magnetic resonance image and the measured k-space data |
| 212 | iterations finished? |
| 214 | provide the intermediate magnetic resonance image or the de-noised magnetic resonance image as a reconstructed magnetic resonance image after the iterative steps are complete |
| 300 | medical instrumnet |
| 302 | magnetic resonance imaging system |
| 304 | magnet |
| 306 | bore of magnet |
| 308 | imaging zone |
| 309 | region of interest |
| 310 | magnetic field gradient coils |
| 312 | magnetic field gradient coil power supply |
| 314 | radio-frequency coil |
| 316 | transceiver |
| 318 | subject |
| 320 | subject support |
| 330 | pulse sequence commands |
| 400 | receiving a fully sampled magnetic resonance image reconstructed from fully sampled k-space data |
| 402 | receiving training k-space data, wherein the training k-space data is a subset of the sampled k-space data |
| 404 | reconstructing an initial training image from the training k-space data |
| 406 | setting the initial training magnetic resonance image as an input training magnetic resonance image |
| 408 | receiving a de-noised training magnetic resonance image from the convolutional neural network in response to inputting the input training magnetic resonance image into the convolutional neural network |
| 410 | receiving the intermediate training image from the compressed sensing data consistency module in response to inputting the de-noised training magnetic resonance image and the training k-space data |
| 412 | iterations finished? |
| 414 | providing the intermediate training magnetic resonance image or the de-noised training magnetic resonance after as a reconstructed training image after the iterative steps are complete |
| 416 | calculating a loss function from the training magnetic resonance image and the fully sampled magnetic resonance image |
| 418 | training the convolutional neural network by iteratively back propagating the loss function through the compressed sensing data consistency module and the convolutional neural network |
| 500 | k-space mask |
| 502 | coil sensitivity profiles |
| 600 | first portion |
| 602 | trainable filter layer |
| 604 | second portion |
| 606 | first convolutional layer |
| 608 | first rectifier unit layer |
| 610 | first pooling layer |
| 612 | second convoluational layer |
| 614 | second rectifier unit layer |
| 616 | second pooling layer |
| 618 | first intermediate convoluation layer |
| 620 | first intermediate rectifier unit layer |
| 622 | second intermediate convoluation layer |
| 624 | second intermediate rectifier unit layer |
| 626 | first up sampling layer |
| 628 | first concatination layer |
| 630 | third convoluation layer |
| 632 | third rectigier unit layer |
| 634 | second up samplig layer |
| 636 | second concation layer |
| 638 | fourth convolutional layer |
| 640 | fourth rectifier unit layer |

| 650 | first skip connection |
| 652 | second skip connection |
| 660 | fifth convolutional layer |
| 662 | fifth rectifier unit layer |
| 664 | third pooling layer |
| 666 | sixth convolutional layer |
| 668 | sixth rectifier unit layer |
| 670 | fourth pooling layer |
| 672 | third intermediate convoluation layer |
| 674 | third intermediate rectifier unit layer |
| 676 | fourth intermediate convoluation layer |
| 678 | fourth intermedaite rectifier unit layer |
| 680 | third upsampling layer |
| 682 | third concatination layer |
| 684 | seventh convoluational layer |
| 686 | seventh rectifier unit layer |
| 688 | fourth upsampling layer |
| 690 | fourth concatinaiotn layer |
| 692 | eightth convoluational layer |
| 694 | eightth rectifier unit layer |
| 696 | third skip connection |
| 698 | fourth skip connection |
| 800 | first trainable filter layer |
| 802 | second trainable filter layer |
| 900 | zero-filled reconstruction |
| 1100 | fully sampled magnetic resonance image |

**Claims**

1. A medical instrument (100, 300) comprising:

- a memory (110) storing machine executable instructions (120), a convolutional neural network (122, 122', 122", 122'''), and a compressed sensing data-consistency module (124); wherein the convolutional neural network is configured to output a de-noised magnetic resonance image (132) in response to inputting an input magnetic resonance image (130), wherein the convolutional neural network is a multiscale deep neural network, wherein the convolutional neural network comprises a first portion (600) implementing a sparsifying transform, wherein the compressed sensing data consistency module is configured to generate an intermediate image (134) by increasing consistency of the de-noised magnetic resonance image with measured k-space data (126); and
- a processor (106) configured to control the medical instrument, wherein execution of the machine executable instructions causes the processor to:

  - receive (202) the measured k-space data
  - reconstruct (204) an initial magnetic resonance image (128) from the measured k-space data;
  - set (206) the initial magnetic resonance image as the input magnetic resonance image;
  - iteratively generate the intermediate magnetic resonance image and the de-noised magnetic resonance image by repeating the following steps a predetermined number of times:

    - receive (208) the de-noised magnetic resonance image from the convolutional neural network in response to inputting the input magnetic resonance image into the convolutional neural network;
    - receive (210) the intermediate image from the compressed sensing data consistency module in response to inputting the de-noised magnetic resonance image and the measured k-space data;

  - provide (214) the intermediate magnetic resonance image or the de-noised magnetic resonance image as a reconstructed magnetic resonance image (136) after the iterative steps are complete.

2. The medical instrument of claim 1, wherein the first portion implementing the sparsifying transform comprises:

- a first rectifier unit layer (608);
- a first pooling layer (610), wherein the first rectifier unit is before the first pooling layer;
- a second rectifier unit layer (614) after the first pooling layer;
- a second pooling layer (616), wherein the second pooling layer is after the second rectifier unit, wherein the second rectifier is after the second rectifier layer;
- a first upsampling layer (626) after the second pooling layer;
- a first concatenation layer (628) after the first upsampling layer;
- a second upsampling layer (634) after the first concatenation layer;
- a second concatenation layer (636) after the second upsampling layer;
- a first skip connection (650) between the first rectifier layer and the second concatenation layer; and
- a second skip connection (652) between the second rectifier layer and the first concatenation layer.

3. The medical instrument of claim 2, wherein the first portion is configured to output an intermediate sparsified image representation, wherein the convolutional neural network further comprises a trained filter layer (602) configured for receiving the sparsified image representation and in response outputting a filtered sparsified image representation, wherein the convolutional neural network further comprises a second neural network portion (604) configured for outputting the de-noised magnetic resonance image in response to receiving the filtered sparsified image representation.

4. The medical instrument of claim 3, wherein the first neural network portion and the second neural network portion are symmetric (122').

5. The medical instrument of claim 3, wherein the first neural network portion and the second neural network portion are asymmetric (122").

6. The medical instrument of claim 1 or 2, wherein the first portion (122''') is configured to output the de-noised magnetic resonance image.

7. The medical instrument of any one of the preceding claims, first portion further comprises:

   - a first trainable filter layer (800) between the first concatenation layer and the second upsampling layer; and
   - a second trainable filter layer (802) after the second concatenation layer.

8. The medical instrument of any one of the preceding claims, wherein the measured k-space data is parallel imaging k-space data, wherein execution of the machine executable instructions further causes the processor to receive coil sensitivity profiles, wherein the initial magnetic resonance image is reconstructed from the measured k-space data and the coil sensitivity profiles; wherein the intermediate image is generated by the compressed sensing data consistency module using the de-noised magnetic resonance image, the measured k-space data, and the coils sensitivity profiles.

9. The medical instrument of any one of the preceding claim, wherein the medical instrument further comprises a magnetic resonance imaging system (302) configured to acquire the measured k-space data from an imaging zone (308), wherein the memory further contains pulse sequence commands (330) configured for controlling the magnetic resonance imaging system to acquiring the measured k-space data according to a compressed sensing magnetic resonance imaging protocol, wherein execution of the machine executable instructions further cause the processor to acquire the measured k-space data by controlling (200) the magnetic resonance imaging system with the pulse sequence commands.

10. The medical instrument of any one of the preceding claims, wherein execution of the machine executable instructions further causes the processor to train the convolutional neural network by:

    - receiving (400) a fully sampled magnetic resonance image reconstructed from fully sampled k-space data;
    - receiving (402) training k-space data, wherein the training k-space data is a subset of the sampled k-space data;
    - reconstructing (404) an initial training image from the training k-space data;
    - setting (406) the initial training magnetic resonance image as an input training magnetic resonance image;
    - iteratively generate an intermediate training magnetic resonance image and a de-noised training image by repeating the following steps the predetermined number of times:

- receiving (408) a de-noised training magnetic resonance image from the convolutional neural network in response to inputting the input training magnetic resonance image into the convolutional neural network;
- receiving (410) the intermediate training image from the compressed sensing data consistency module in response to inputting the de-noised training magnetic resonance image and the training k-space data;

- providing (414) the intermediate training magnetic resonance image or the de-noised training magnetic resonance after as a reconstructed training image after the iterative steps are complete;
- calculating (416) a loss function from the training magnetic resonance image and the fully sampled magnetic resonance image;
- training (418) the convolutional neural network by iteratively back propagating the loss function through the compressed sensing data consistency module and the convolutional neural network.

11. The medical instrument of any one of the preceding claims, wherein the memory contains a single instance of the convolutional neural network used for each iterative generation of the intermediate magnetic resonance image.

12. The medical instrument of any one of claims 1 through 10, wherein the memory contains a distinct instance of the convolutional neural network for each iterative generation of the intermediate magnetic resonance image.

13. A method of providing a reconstructed magnetic resonance image (136) using a convolutional neural network (122, 122', 122", 122''') and a compressed sensing data-consistency module (124), wherein the convolutional neural network is configured to output a de-noised magnetic resonance image (132) in response to inputting an input magnetic resonance image (130), wherein the convolutional neural network is a multiscale deep neural network, wherein the convolutional neural network comprises a first portion (600) implementing a sparsifying transform, wherein the compressed sensing data consistency module is configured to generate an intermediate image by increasing consistency of the de-noised magnetic resonance image with the measured k-space values, wherein the method comprises:

- receiving (202) the measured k-space data
- reconstructing (204) an initial magnetic resonance image from the measured k-space data;
- setting (206) the initial magnetic resonance image as the input magnetic resonance image;
- iteratively generating the intermediate magnetic resonance image and de-noised magnetic resonance image by repeating the following steps a predetermined number of times:

- receiving (208) the de-noised magnetic resonance image from the convolutional neural network in response to inputting the input magnetic resonance image into the convolutional neural network, and
- receiving (210) the intermediate image from the compressed sensing data consistency module in response to inputting the de-noised magnetic resonance image and the measured k-space data; and

- providing (214) the intermediate magnetic resonance image or the de-noised image as a reconstructed magnetic resonance image after the iterative steps are complete.

14. A computer program product comprising machine executable instructions (120), a convolutional neural network (122, 122', 122", 122''), and a compressed sensing data-consistency module (124), wherein the convolutional neural network is configured to output a de-noised magnetic resonance image (132) in response to inputting an input magnetic resonance image (130), wherein the convolutional neural network is a multiscale deep neural network, wherein the convolutional neural network comprises a first portion (600) implementing a sparsifying transform, wherein the compressed sensing data consistency module is configured to generate an intermediate image (134) by increasing consistency of the de-noised magnetic resonance image with the measured k-space data (126), wherein execution of the machine executable instructions causes the processor to:

- receive (202) the measured k-space data;
- reconstruct (204) an initial magnetic resonance image from the measured k-space data;
- set (206) the initial magnetic resonance image as the input magnetic resonance image;
- iteratively generate the intermediate magnetic resonance image and de-noised magnetic resonance image by repeating the following steps a predetermined number of times:

- receive (208) the de-noised magnetic resonance image from the convolutional neural network in response to inputting the input magnetic resonance image into the convolutional neural network;

- receive (210) the intermediate image from the compressed sensing data consistency module in response to inputting the de-noised magnetic resonance image and the measured k-space data;

- provide (214) the intermediate magnetic resonance image or the de-noised image as a reconstructed magnetic resonance image (136) after the iterative steps are complete.

Fig. 1

acquire measured
k-space data — 200

receive measured
k-space data — 202

reconstruct initial
MR image — 204

set initial MR image as
the input MR image — 206

calculate de-noised
MR image — 208

calculated intermediate
image — 210

iterations
finished? — 212

No

Yes → provide the
reconstructed
MR image — 214

Fig. 2

Fig. 3

receive fully sampled
MR image — 400

receive training
k-space data — 402

reconstruct initial
training MR image — 404

set initial training
MR image as the input
training
MR image — 406

calculate de-noised
training Mr image — 408

train convolutional
neural network — 418

calculate intermediate
training image — 410

calculate loss
function — 416

iterations
finished? — 412

No                    Yes

provide the
reconstructed
training image — 414

Fig. 4

Fig. 5

Fig. 6

EP 3 825 711 A1

Fig. 7

Fig. 8

EP 3 825 711 A1

900

Fig. 9

136

Fig. 10

1100

Fig. 11

Europäisches
Patentamt

European
Patent Office

Office européen
des brevets

**EUROPEAN SEARCH REPORT**

Application Number

EP 19 21 1148

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br>A | CN 108 717 717 A (UNIV SOUTHEAST)<br>30 October 2018 (2018-10-30)<br>* Paragraphs [0006], [0028] and [0038]-[0051];<br>figure 1 * | 1-10,<br>12-14<br>11 | INV.<br>G01R33/56<br>G06N3/08<br>G06T5/00<br>G06T9/00<br>G06T11/00 |
| X<br><br><br><br><br><br><br>A | JO SCHLEMPER ET AL: "A Deep Cascade of Convolutional Neural Networks for MR Image Reconstruction",<br>ARXIV.ORG, CORNELL UNIVERSITY LIBRARY, 201 OLIN LIBRARY CORNELL UNIVERSITY ITHACA, NY 14853,<br>2 March 2017 (2017-03-02), XP080753653,<br>DOI: 10.1007/978-3-319-59050-9_51<br>* sections 1,2,4,5 and 7;<br>figure 1 * | 1-10,<br>12-14<br><br><br><br><br><br>11 | ADD.<br>G06N3/04 |
| X<br><br><br><br><br><br><br>A | HEMANT KUMAR AGGARWAL ET AL: "MoDL: Model Based Deep Learning Architecture for Inverse Problems",<br>ARXIV.ORG, CORNELL UNIVERSITY LIBRARY, 201 OLIN LIBRARY CORNELL UNIVERSITY ITHACA, NY 14853,<br>7 December 2017 (2017-12-07), XP081324091,<br>DOI: 10.1109/TMI.2018.2865356<br>* abstract, section III;<br>figure 1 * | 1,2,<br>5-11,13,<br>14<br><br><br><br><br>12 | |

TECHNICAL FIELDS
SEARCHED (IPC)

G01R
G06T
G06N

-/--

The present search report has been drawn up for all claims

| Place of search | Date of completion of the search | Examiner |
|---|---|---|
| Munich | 13 May 2020 | Lebar, Andrija |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons
...............................................................
& : member of the same patent family, corresponding
    document

EPO FORM 1503 03.82 (P04C01)

Europäisches
Patentamt

European
Patent Office

Office européen
des brevets

# EUROPEAN SEARCH REPORT

Application Number

EP 19 21 1148

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | TAEJOON EO ET AL: "KIKI-net: cross-domain convolutional neural networks for reconstructing undersampled magnetic resonance images", MAGNETIC RESONANCE IN MEDICINE., vol. 80, no. 5, 6 April 2018 (2018-04-06), pages 2188-2201, XP055637216, US ISSN: 0740-3194, DOI: 10.1002/mrm.27201 | 1-10, 12-14 | |
| A | * paragraph bridging left and right column on p. 2189; figures 1,2 * <br> * sections 2.4, 2.5, 3.1 and 3.2 * | 11 | |
| X | CN 108 828 481 A (ZHU GAOJIE) 16 November 2018 (2018-11-16) | 1-10, 12-14 | |
| A | * paragraph [0008] - paragraph [0096]; figures 1,2 * | 11 | |

TECHNICAL FIELDS
SEARCHED      (IPC)

The present search report has been drawn up for all claims

| Place of search | Date of completion of the search | Examiner |
|---|---|---|
| Munich | 13 May 2020 | Lebar, Andrija |

EPO FORM 1503 03.82 (P04C01)

## ANNEX TO THE EUROPEAN SEARCH REPORT
## ON EUROPEAN PATENT APPLICATION NO.

EP 19 21 1148

This annex lists the patent family members relating to the patent documents cited in the above-mentioned European search report.
The members are as contained in the European Patent Office EDP file on
The European Patent Office is in no way liable for these particulars which are merely given for the purpose of information.

13-05-2020

| Patent document cited in search report | | Publication date | Patent family member(s) | Publication date |
|---|---|---|---|---|
| CN 108717717 | A | 30-10-2018 | NONE | |
| CN 108828481 | A | 16-11-2018 | NONE | |

EPO FORM P0459

For more details about this annex : see Official Journal of the European Patent Office, No. 12/82

**EP 3 825 711 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **ZHANG, J. ; GHANEM, B.** ISTA-Net: Interpretable optimization-inspired deep network for image compressive sensing. *Proceedings of the IEEE Conference on Computer Vision and Pattern Recognition,* 2018, 1828-1837